Europäisches Patentamt

European Patent Office

Office européen des brevets

(11) Publication number: **0 073 528**
**A2**

# (12) EUROPEAN PATENT APPLICATION

(21) Application number: **82108111.4**

(22) Date of filing: **02.09.82**

(51) Int. Cl.³: **H 01 R 9/07**

(30) Priority: **02.09.81 US 298885**

(43) Date of publication of application: **09.03.83**
**Bulletin 83/10**

(84) Designated Contracting States: **DE FR GB**

(71) Applicant: **Litton Systems, Inc., 360 North Crescent Drive, Beverly Hills California 90210 (US)**

(72) Inventor: **Knowles, Robert G., South Lake Street, Litchfield Connecticut 06759 (US)**
Inventor: **Sikorski, Michael J., 10 Park Lane, Newtown Connecticut 06470 (US)**

(74) Representative: **Patentanwälte TER MEER - MÜLLER - STEINMEISTER, Triftstrasse 4, D-8000 München 22 (DE)**

(54) Connector for a flex membrane.

(57) A connector for coupling membrane connectors (22) on a flex membrane to the conductive tracers (17) on a printed circuit board (16) comprises an elongated connector body (11) having a resilient pressure member (12) mounted along the lower edge thereof. The pressure member overlies the flex membrane and biasing means (13) draw the connector body to the printed circuit board pressing the membrane connectors (22) into contact with the conductive tracers (17).

ACTORUM AG

COMPLETE DOCUMENT

- 2 -

## BACKGROUND OF THE INVENTION

This invention relates to a connector for coupling a flex membrane to a printed circuit board.

The use of membrane switches and of flex membranes is becoming prevalent in the electrical arts. The membrane switch is a completely sealed unit which is activated by pressure applied to selected areas thereof. The switch is coupled to a printed circuit board by a flex membrane which comprises a Mylar strip on which conductive metallized ink paths have been formed. Various methods have been used to connect the flex membrane to printed circuit boards. Because the Mylar is thin and the metallized ink paths are fragile, conventional techniques such as crimping or soldering are unacceptable.

## SUMMARY OF THE INVENTION

A connector for use with flex membranes comprises an elongated body and a resilient pressure member which is urged by biasing members to press the conductive portions of a flex membrane into intimate contact with the printed circuit board tracers. The pressure member is shaped so that a gas-tight seal is formed to protect the connection thus established from the environment.

It is therefore an object of the present invention to provide a connector which is especially suited for coupling a flex membrane to a printed circuit board.

Figure 1 is an exploded perspective view of a flex membrane connector, a flex membrane, and a printed circuit board.

Figure 2 is an end sectional view of the connector of Figure 1 securing a flex membrane against a printed circuit board.

Figure 3 is a front sectional view of the connector of Figure 2.

## DESCRIPTION OF THE PREFERRED EMBODIMENT

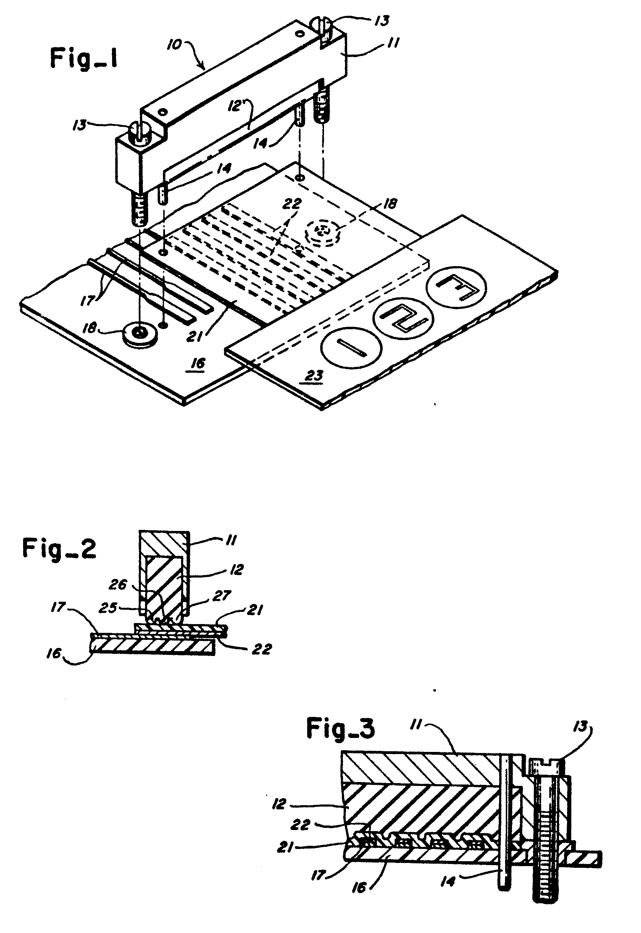

Figure 1 shows generally at reference numeral 10 a flex membrane connector according to the instant invention. The connector comprises an elongated body 11 having a pressure member 12 located on the lower surface thereof. The body includes two biasing means in the form of threaded screws 13 and two alignment pins 14.

The printed circuit board 16 includes conductive printed circuit board tracers 17 which are formed thereon in a manner well known in the art. Threaded apertures 18 formed in the printed circuit board 16 are spaced to receive the threaded screws 13 in the connector body 11.

A flex membrane 20 comprises a flexible sheet 21 of 8-10 mil polyester film, such as Mylar, on the underside of which is printed a plurality of conductive ink paths 22. The flex membrane is coupled to a membrane switch 23 as will be readily appreciated by those skilled in the art.

Turning now to Figure 2, it will be seen that the pressure member 12 comprises a resilient material, such as rubber, having three lobes 25, 26 and 27 integrally formed therewith. These lobes extend along the length of the pressure member 12 and act in unison to press the flex membrane against the surface of the printed circuit board along the three lines of force.

Turning now to Figure 3, it will be seen that the downward force of the pressure member 12 on the flex membrane 20 not only presses the conductive ink paths 22 into intimate contact with the printed circuit board tracers 17, but also causes the polyester sheet 21 to follow the castellated contour presented by the tracers 17 on the printed circuit board 16.

- 4 -

Accordingly, a seal is formed between the film and the board beneath each of the lobes 25, 26 and 27 and the outer seal beneath the lobes 25 and 27 will prevent the contamination by moisutre or other foreign matter of the electrical interface between the conductive ink 22 and the tracers 17 which is located beneath the central lobe 26.

The alignment pins 14 insure correct relative alignment between the metallized ink paths 22 and the conductive circuit board tracers 17. The alignment pins 14 further act as a strain relief preventing withdrawal of the flex membrane 20 from a position between the connector 10 and the printed circuit board 16.

Having thus described the invention, various alterations and modifications will occur to those skilled in the art, which alterations and modifications are intended to be within the scope of the invention as defined by the appended claims.

CLAIMS:

1.    A connector for coupling the membrane connectors on a flex membrane to the tracers on a printed circuit board wherein the connector comprises an elongated connector body (11), and a strain relief (14) mounted on the connector body and adapted to engage the flex membrane and the printed circuit board, characterized in that a resilient pressure member (12) is mounted along the lower edge of the connector body and overlies the membrane, and biasing means (13) draw the connector body to the printed circuit board, whereby the resilient pressure member presses on the flex membrane to create a gas tight interface between the membrane conductors and the printed circuit board tracers.

2.    The connector of claim 1 further characterized in that a rubber pad comprises the resilient pressure member, and three parallel elongated lobes (25, 26, 27) are formed along the entire bottom surface of the rubber pad, wherein the biasing means causes the two outside lobes (25, 27) to seal gas and moisture from the region of the inner lobe (26).

Fig_1

Fig_2

Fig_3

1/1  0073528